# EUROPEAN PATENT SPECIFICATION

(11) **EP 2 936 555 B1**
(45) Date of publication and mention of the grant of the patent: **12.09.2018**
(21) Application number: 13766157.5
(22) Date of filing: 16.01.2013
(51) Int. Cl.: H01L 23/367, H01L 23/373, H01L 23/047

(54) **CHIP PACKAGE ASSEMBLY AND METHOD TO USE THE ASSEMBLY**
CHIPPAKETANORDNUNG UND VERFAHREN ZUR ANWENDUNG DIESER ANORDNUNG
ENSEMBLE BOÎTIER DE PUCES ET PROCÉDÉ D'UTILISATION DE L'ENSEMBLE

(43) Date of publication of application: 28.10.2015
(73) Proprietor: Limited Liability Company "Siemens", Moscow 115184 (RU)
(72) Inventor: IVANOV, Evgeny Valeryevich, Moscow 125481 (RU); KRASNOV, Andrey Aleksandrovich, Moscow 117279 (RU); SHARKOV, Georgy Borisovich, Moscow 115172 (RU); TIKHOMIROVA, Nadezhda Vladimirovna, Rybinsk 152919 (RU)
(74) Representative: Isarpatent
(86) International application number: PCT/RU2013/000031
(87) International publication number: WO 2014/112892

(56) References cited:
- EP-A1- 1 672 692
- US-A- 3 958 195
- US-A- 5 760 473
- US-A1- 2010 008 046
- US-A1- 2010 091 477
- US-A1- 2012 032 190

## Description

The present invention relates to a chip package assembly and its use for mounting at least one semiconductor chip, comprising a flange and a substrate, where the at least one chip and the substrate are arranged on one side of the flange.

The present invention describes a chip package assembly which can be used for mounting and encapsulation of semiconductor chips containing for example vertical junction field effect transistors (VJFET). Inter alia high power RF semiconductor devices can be composed of VJFET structures. Chip packages are known for example from US6,318,622B1, US6,967,400B2, US6,465,883B2 and US7,256,494B2.

In US6,318,622B1 an assembly of high power chips is described, which mounts to an additional substrate. Semiconductor chips are electrically connected to the main substrate by bonding wires. Ribbon connectors are used for external electrical connection. To protect the internal structure of the assembly an extra cap is used. In US6,967,400B2 an IC chip package is described, including a substrate, a chip, adhesive means, a cover and a spacer. Vias at the end faces of the substrate are used for external electrically connection, where bonding wires are passing through the vias. This gives a good possibility to connect the semiconductor chip electrically with outside the package.

Two main problems arise from described assemblies, the problem of connecting several substrates together and the problem of heat transfer. High power devices produce in practice huge amounts of heat during usage. This heat has to be transferred to the environment, not to exceed a critical temperature of the device and in worst case not to destroy the devices by a temperature exceeding the critical temperature. There is no possibility given to improve heat transfer, for example by usage of external cooling blocks.

In US6,465,883B2 a high power transistor chip for high frequencies is coupled to an electrically and thermally conductive flange at its backside. In US7,256,494B2 a chip package is described including a heat spreader at the backside of a chip. There are electrical connectors for gate and drain of a transistor to be electrically connected with the substrate mount on top of the flange or heat spreader. The described assemblies exhibit good thermal properties, but can be only restrictively used for applications where electrical insulation of flange or heat spreader from the ground is required. This electrical insulation is required for example with usage of VJFET chips with drain connector located at the bottom of the chip.

The object of the present invention is to present a chip package assembly with high efficiency of heat removal from a semiconductor chip, particularly for chips with a transistor drain contact connection on the bottom side of the chip. The bottom side of the chip is the side opposite to the side with other electrical contacts like for example source contacts and electrical connections of the chip to external devices. The bottom side is the side with which the chip is arranged on a mounting structure. A further object of the present invention is to present a chip package assembly and method of use with ability of mounting and demounting the chip from the assembly. If the semiconductor chip shows a failure it should be easy to remove and/or exchange the chip with a properly working one.

The above objects are achieved by the chip package assembly according to claim 1 and the method to use it according to claim 15.

The Chip package assembly for mounting at least one semiconductor chip according to the present invention comprises a flange and a substrate, where the at least one chip and the substrate are arranged on one side of the flange. In this case the flange is the previously described mounting structure. The flange is composed of an electrical and thermally conducting material. The chip package assembly comprising at least one cooling device, particularly a cooling block. The chip package assembly comprising a dielectric substrate between the flange and the cooling device, particularly in plate form. It can be arranged on the opposite side of the flange, to the one side of the flange where the at least one chip and the substrate are arranged, for electrical isolation. This means that the material has a low electrical and thermal resistance compared to other materials like isolators.
The advantage of the chip package assembly according to the present invention is a high efficiency of heat removal from the at least one semiconductor chip due to the flange. The chip can have a transistor drain contact connection on the bottom side of the chip and still the flange can be thermally coupled to this side. The assembly is easy to use and easy to assemble, with a low number of parts, is cost effective and can be used in high frequency applications.
The conducting material of the flange can comprise or can be made of a metal, particularly a metal with high thermal conductivity, particularly copper. A flange made of copper shows a high thermal conductivity and is able to transfer heat well away from the chip, which is produced for example in high power applications of the chip. The cooling and keeping the chip below a critical temperature also in use prevents damage and failure of the chip.

The substrate can comprise a material with low losses at high frequencies. The substrate can for example be made of printed circuit board (PCB) material. This material does not adsorb much signal in high frequency applications; radiation with high frequency can pass it with little or no loss. PCB material is cheap, can be easy handled, is mechanically stable and other electronic or electric components like electrical contacts can easy be arranged on it.
The at least one chip can comprise a transistor drain contact connection at the bottom side. The bottom side is the side facing the flange and is particularly opposite to the side with the other electrical contacts of the at least one chip. The chip package assembly according to the present invention allows also for a chip with a transistor drain contact connection at the bottom side to fix it at the same side to a flange, respectively a cooling device.

The at least one chip and/or substrate can be mounted on the one side of the flange using solder, eutectic alloy, electrical conductive adhesive and/or sinter paste. This allows easy and cost effective to arrange the at least one chip and/or substrate to the flange.

Connectors of the at least one chip, particularly the connectors on the side of the at least one chip opposite the side facing the flange, can be connected to the substrate by bonding, particularly by bonding with wires and/or ribbon lines. This gives an easy and good electrical connection between the at least one chip and the substrate.

The chip package assembly can comprise electrical outlets for high frequency requirements connectable to external devices, particularly to an amplifier Printed Circuit Board. This makes it easy to use the chip package assembly in high frequency applications.

The substrate can comprise end side metalized places for electrical contact, particularly in electrical contact to the at least one chip, for electrical contact to at least one external device. The end side metalized places can be arranged at the side face of substrate and/or soldered for contact to the at least one external device. The arrangement of the end side of metalized parts of substrate for electrical contact at side faces and soldering makes it easy to electrically contact external devices to the contacts. This arrangement makes it easy to contact electrically the chip with external devices. The end side metalized places are easy to reach for electrically connection.

The chip package assembly can comprise an electrical isolation between the connectors of the at least one chip and the flange. This prevents short circuits over the flange of the chip contacts, especially for good electrically conducting flanges like the one made of copper.

Also other active or passive cooling devices can be thermally connected to the flange of the chip package assembly. For example devices with a water cooling circuit or with air fan can be used. This enables a good cooling of the at least one chip even in high power application with high amount of waste heat. The chip package assembly can also comprise means for mounting the flange with the at least one chip and the substrate to the cooling device. This means can be for example screws.
An electrical isolation can be arranged between the connectors of the at least one chip and the cooling device. This prevents short circuits between connectors and/or via the cooling device.

The chip package assembly can further comprise an encapsulation to protect the at least one chip and connectors. The encapsulation can be removable. This enables an easy exchange of chips from the assembly for example if the used chip has a fail function.
The chip package assembly can comprise screws through dielectric sleeves to fasten the at least one chip, substrate and flange to the cooling device. This enables an easy, fast and reliable assembling of the chip package assembly without electrical short circuits due to the screws.

A method to use the chip package assembly according to the present invention comprises demounting of the chip package, particularly to demount the at least one chip from the substrate. This is also enabled by the arrangement of parts as described before for the chip package assembly itself. It allows to exchange the at least one chip, especially if it shows a failure, with an other, properly working chip.

The advantages in connection with the described method to use the chip package assembly according to the present invention are similar to the previously, in connection with the chip package assembly described advantages.

The present invention is further described hereinafter with reference to illustrated embodiments shown in the accompanying drawings, in which:
- FIG. 1: illustrates an embodiment of a chip package assembly 1 for mounting at least one semiconductor chip 2 according to the present invention, and
- FIG. 2: illustrates the chip package assembly 1 of FIG. 1 with means for mounting it to a cooling device (not shown).

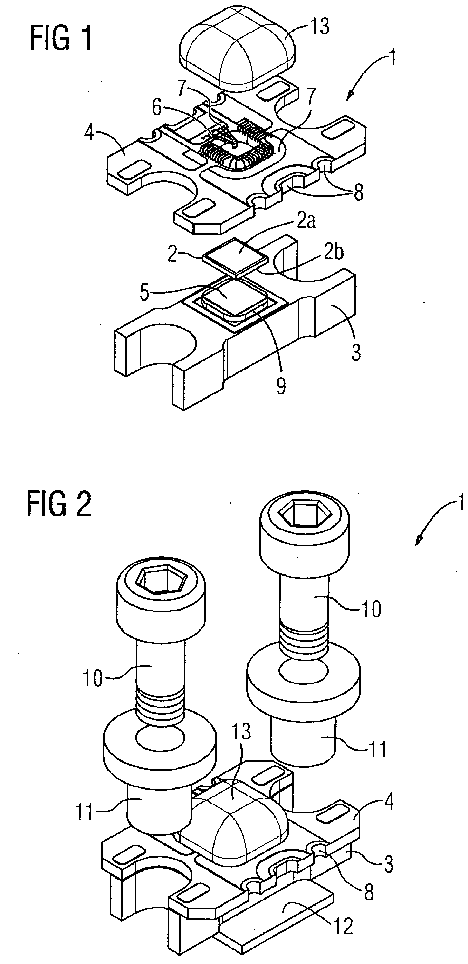

In FIG. 1 is shown an embodiment of the chip package assembly 1 according to the present invention, for mounting at least one semiconductor chip 2. The chip package assembly 1 comprises a semiconductor chip 2, particularly with transistor connections for example for gate and source on the top side of the chip 2a and with drain connection on the bottom side of the chip 2b. The chip package assembly 1 further comprises a flange 3, on which the chip 2 and a substrate 4 are arranged on one side. The flange 3 works as a cooling device, which has a good thermal conductivity.

During usage, the chip 2 produces waste heat. In high power applications the waste heat can increase the temperature of the chip 2 and damage it. That's why heat has to be removed and transferred to the environment, to cool down the chip 2 and/or to keep the temperature of the chip 2 below a critical temperature. Above the critical temperature the electronic device of the chip 2 can show failure and/or can be damaged. The flange 3, which is in good thermal contact to the chip 2, absorbs the waste heat of the chip 2 and transfers it directly to the environment or to an additional cooling device, which is not shown in the figures for simplicity. An appropriate material for the flange 3 to consist of or to comprise is a metal with high thermal conductivity, for example copper.

For good mechanical and thermal connection between the chip 2 and the flange 3 materials 5 for attachment of the chip 2 are solders, eutectic alloys, electrical conductive adhesives and/or sinter paste. The chip 2 and/ or substrate 4 can be mounted on one and the same side of the flange using these materials. In between the chip 2 and the flange 3 an electrical isolation 9 can be arranged. The electrical isolation can be made of a plate like isolating material. It prevents short circuits between the electrical connectors of the at least one chip 2 and electrical contacts between the chip 2 and the flange 3.

The substrate 4 is arranged on the same side of the flange 3 as the chip 2, and it can comprise a recess within, where the chip 2 can be arranged. Electrical outlets 7 on the substrate 4 are used to electrically contact the chip 2. One way of electrically connect the chip 2 and substrate 4 is bonding, for example bonding with wires and/or ribbon lines 6. The electrical outlets 7 can extend to end side metalized places of substrate 8. They can be arranged at side faces of the substrate 4 and can be soldered. The end side metalized places of substrate 8 are suitable for electrical connection with external devices, for example by wires soldered to the places 8. Via the end side metalized places and the electrical outlets 7 of substrate 8, bonded for example with wires and/or ribbon lines 6 to contact connections of the chip 2, the chip 2 can be electrically connected with external devices, not shown in figures for simplicity.

On top of the chip 2, with its contact connections and bonded wires and/or ribbon lines 6, an encapsulation 13 can be arranged to protect the chip 2 and connections mechanically and electrically. The encapsulation 13 or cover can be made of a polymer, which is not electrically conducting. It can be arranged and connected removable from the assembly to be able to exchange the chip 2 if necessary.

As shown in FIG. 2 the chip package assembly 1 can comprise means 10, 11 for mounting it to an additional cooling device, which is not shown for simplicity. The cooling device can for example be a plate with fin structure or water cooled heat exchanger. Possible means for mounting are screws 10 which can be screwed into the cooling device and with their screw heads the substrate 4 and flange 3 can be compressed or clamped together and to the additional cooling device. A dielectric substrate 12 can be arranged between the flange 3 and the cooling device to electrically isolate the flange 3 from the cooling device. The isolation can be necessary in high frequency applications, if a current is induced in the flange 3. The isolation reduces induction losses by induced currents. The substrate 4, flange 3, isolator 12 and cooling device can be arranged in form of a sandwich structure, which is compressed and fixed to each other by the screws 10.

Dielectric sleeves 11 can be used to electrically isolate the screws 10 from the flange 3. The sleeves 11 can have a cupped form with washer head. The chip package assembly 1 can be clamped together in a sandwich like form by the means 11 and 12, and be mechanically stable fixed or mounting to the cooling device.

Isolation of electrical conductive parts like flange 3, external cooling device and screws from each other, can improve the performance of the assembly 1 and makes its use possible in high frequency applications.

Features of the above described embodiments of the invention with itself and features from embodiments known from the state of the art can be combined. Different materials and forms of parts of the described assembly 1 are possible. For example the flange 3 can be made instead of copper out of steel or other materials, particularly metals. The H like shape of the substrate 4 and the flange 3, with recesses for means 10, 11 to fix the assembly 1 together, can for example also have a shape of an 8. Instead of an external cooling device nuts can be used in connection with screws 10 to clamp
the assembly 1 together.

A method to use the chip package assembly 1 comprises to mount the chip 2 on the flange 3, for example by using solder, eutectic alloy, electrical conductive adhesive and/or sinter paste 5. In between an electrical isolation 9 can be arranged. Around the chip 2, on the same side of the flange 3 a substrate 4 is arranged, for example also by using solder, eutectic alloy, electrical conductive adhesive and/or sinter paste 5. The chip 2 and electrical outlets 7 of the substrate 4 are electrically connected together for example by bonding with bond wires or ribbon lines 6. The electrical outlets 7 can extend to side faces of the substrate 4, which can be soldered for good electrical contact to external electrical devices like amplifiers. Arranging the chip 2 on the flange 3 and not direct on the substrate 4, can permit a better heat transfer between chip 2 and flange 3.

An encapsulation 13 can be arranged on top of the chip 2 and on top of electrical connections 6 to the outlets 7 of substrate 4. The encapsulation 13 can be in form of a cap, which is removable. Alternatively the chip 2 can be enclosed in a casting compound. This can be a usual polymer used in the semiconductor industry to encapsulate semiconductor chips.

The use of removable encapsulation 13, which can be clamped by the means 10, 11 or glued to the substrate 4, enables an easy exchange of the chip 2. The chip package assembly 1 can be demounted, particularly the at least one chip (2) can be demounted from the substrate 4. For example, if the mounted chip 2 shows fail function in use, the chip 2 can be exchanged with an other, properly working chip. After removal of the encapsulation 13 bonding material 6 is removed, the chip 2 is peeled of the flange 3, a new chip 2 is arranged on the flange 3 and for example is fixed using solder, eutectic alloy, electrical conductive adhesive and/or sinter paste 5. The chip 2 connections and electrical outlets 7 on the substrate 4 are bonded electrically together. And the encapsulation is affixed to the assembly 1 for example on top of the chip 2, as shown in Fig. 1 and 2.

Other additional steps are possible. For example a cleaning step of parts can be used to remove glue or solder, eutectic alloy, electrical conductive adhesive and/or sinter paste. The steps of the method according to the present invention can also be performed in an other timely order. Also steps known from the state of the art can be performed alternatively or additionally to the described steps of the method according to the present invention.

### List of Reference Characters

- 1: chip package assembly
- 2: semiconductor chip
- 2a: top side of chip
- 2b: bottom side of chip
- 3: flange
- 4: substrate
- 5: material for attachment of chip
- 6: bonding material
- 7: electrical outlets
- 8: end side metalized places of substrate
- 9: electrical isolation between the connectors of the at least one chip and the flange
- 10: means for mounting the flange with the at least one chip and the substrate to the cooling device, particularly screws
- 11: means for mounting the flange with the at least one chip and the substrate to the cooling device, particularly dielectric sleeves
- 12: dielectric substrate between the flange and the cooling device
- 13: encapsulation

## Claims

1. Chip package assembly (1) for mounting at least one semiconductor chip (2), comprising a flange (3) and a substrate (4), where the at least one chip (2) and the substrate (4) are arranged on one side of the flange (3), the flange (3) is composed of an electrical and thermally conducting material, wherein the chip package assembly further comprises at least one cooling device and wherein **characterized in that**, a dielectric substrate (12) is arranged between the flange (3) and the at least one cooling device, and arranged on the opposite side of the flange (3) to the one side of the flange (3) where the at least one chip (2) and the substrate (4) are arranged.

2. Chip package assembly (1) according to claim 1, **characterized in that** the conducting material of the flange (3) comprises or is a metal, particularly a metal with high thermal conductivity, particularly copper.

3. Chip package assembly (1) according to one of the claims 1 or 2, **characterized in that** the substrate (4) comprises a material with low losses at high frequency, particularly the substrate (4) is made of printed circuit board material.

4. Chip package assembly (1) according to one of the claims 1 to 3, **characterized in that** at least one chip (2) comprises a transistor drain contact connection at the bottom side (2b), where the bottom side (2b) is the side facing the flange (3) and is particularly opposite to the side (2a) with the other electrical contacts of the at least one chip (2).

5. Chip package assembly (1) according to one of the claims 1 to 4, **characterized in that** the at least one chip (2) and/or substrate (4) are mounted on the one side of the flange (3) using solder, eutectic alloy, electrical conductive adhesive and/or sinter paste (5).

6. Chip package assembly (1) according to one of the claims 1 to 5, **characterized in that** connectors of the at least one chip (2), particularly the connectors on the side of the at least one chip (2) opposite the side facing the flange (3), are connected to the substrate (4) by bonding, particularly by bonding with wires and/or ribbon lines (6).

7. Chip package assembly (1) according to one of the claims 1 to 6, comprising electrical outlets (7) for high frequency requirements connectable to external devices, particularly to an amplifier printed circuit board.

8. Chip package assembly (1) according to one of the claims 1 to 7, **characterized in that** the substrate (4) comprises end side metalized places (8) for electrical contact, particularly in electrical contact to the at least one chip (2), for electrical contact to at least one external device.

9. Chip package assembly (1) according to claim 8, **characterized in that** the end side metalized places (8) are arranged at the side face of substrate (4) and/or soldered for contact to the at least one external device.

10. Chip package assembly (1) according to one of the claims 1 to 9, comprising an electrical isolation (9) between the connectors of the at least one chip (2) and the flange (3).

11. Chip package assembly (1) according to one of the claims 1 to 10, wherein the at least one cooling device is a cooling block.

12. Chip package assembly (1) according to claim 11, comprising means (10, 11) for mounting the flange (3) with the at least one chip (2) and the substrate (4) to the at least one cooling device.

13. Chip package assembly (1) according to one of the claims 1 to 12, comprising the dielectric substrate (12) is in plate.

14. Chip package assembly (1) according to one of the claims 1 to 13, comprising an encapsulation (13) to protect the at least one chip (2) and connectors, particularly a removable encapsulation (13), and/or comprising screws through dielectric sleeves to fasten the at least one chip (2), substrate (4) and flange (3) to the at least one cooling device.

15. Method to use the chip package assembly (1) according to one of the claims 1 to 14,
**characterized in that** the chip package is demounted, particularly to demount the at least one chip (2) from the substrate (4), particularly to exchange the at least one chip (2) with an other chip (2).

## Patentansprüche

1. Chippaketanordnung (1) zur Befestigung von mindestens einem Halbleiterchip (2), aufweisend einen Flansch (3) und ein Substrat (4), wobei der mindestens eine Chip (2) und das Substrat (4) auf einer Seite des Flanschs (3) angeordnet sind, wobei der Flansch (3) aus einem elektrischen und wärmeleitenden Material besteht, wobei die Chippaketanordnung ferner mindestens eine Kühlvorrichtung aufweist, und **dadurch gekennzeichnet, dass** ein dielektrisches Substrat (12) zwischen dem Flansch (3) und der mindestens einen Kühlvorrichtung angeordnet ist und auf der Seite des Flanschs (3) angeordnet ist, die der einen Seite des Flanschs (3), an der der mindestens eine Chip (2) und das Substrat (4) angeordnet sind, gegenüberliegt.

2. Chippaketanordnung (1) nach Anspruch 1, **dadurch gekennzeichnet, dass** das leitende Material des Flanschs (3) ein Metall, insbesondere ein Metall mit einer hohen Wärmeleitfähigkeit, insbesondere Kupfer, aufweist oder ist.

3. Chippaketanordnung (1) nach einem der Ansprüche 1 oder 2, **dadurch gekennzeichnet, dass** das Substrat (4) ein Material mit geringen Hochfrequenzverlusten aufweist, wobei das Substrat (4) insbesondere aus einem Leiterplattenmaterial hergestellt ist.

4. Chippaketanordnung (1) nach einem der Ansprüche 1 bis 3, **dadurch gekennzeichnet, dass** der mindestens eine Chip (2) an der unteren Seite (2b) eine Transistor-Drain-Kontaktverbindung aufweist, wobei die untere Seite (2b) die Seite ist, die dem Flansch (3) zugewandt ist und insbesondere der Seite (2a) mit den anderen elektrischen Kontakten des mindestens einen Chips (2) gegenüberliegt.

5. Chippaketanordnung (1) nach einem der Ansprüche 1 bis 4, **dadurch gekennzeichnet, dass** der mindestens eine Chip (2) und/oder das Substrat (4) unter Verwendung von Lot, einer eutektischen Legierung, einem elektrisch leitenden Klebstoff und/oder einer Sinterpaste (5) an der einen Seite des Flanschs (3) befestigt sind.

6. Chippaketanordnung (1) nach einem der Ansprüche 1 bis 5, **dadurch gekennzeichnet, dass** die Anschlüsse des mindestens einen Chips (2), insbesondere die Anschlüsse auf der Seite des mindestens einen Chips (2), die der dem Flansch (3) zugewandten Seite gegenüberliegt, durch Verkleben, insbesondere durch Verkleben mit Drähten und/oder Bandleitungen (6), mit dem Substrat (4) verbunden sind.

7. Chippaketanordnung (1) nach einem der Ansprüche 1 bis 6, aufweisend elektrische Ausgänge (7) für Hochfrequenzanforderungen, die mit externen Vorrichtungen, insbesondere mit einer Verstärkerleiterplatte, verbunden werden können.

8. Chippaketanordnung (1) nach einem der Ansprüche 1 bis 7, **dadurch gekennzeichnet, dass** das Substrat (4) metallisierte Endseitenstellen (8) zur elektrischen Kontaktierung, insbesondere in elektrischem Kontakt mit dem mindestens einen Chip (2), für einen elektrischen Kontakt zu mindestens einer externen Vorrichtung aufweist.

9. Chippaketanordnung (1) nach Anspruch 8, **dadurch gekennzeichnet, dass** die metallisierten Endseitenstellen (8) an der Seitenfläche von Substrat (4) angeordnet sind und/oder zum Kontakt mit der mindestens einen externen Vorrichtung verlötet sind.

10. Chippaketanordnung (1) nach einem der Ansprüche 1 bis 9, aufweisend eine elektrische Isolierung (9) zwischen den Anschlüssen des mindestens einen Chips (2) und dem Flansch (3).

11. Chippaketanordnung (1) nach einem der Ansprüche 1 bis 10, wobei die mindestens eine Kühlvorrichtung ein Kühlblock ist.

12. Chippaketanordnung (1) nach Anspruch 11, aufweisend Mittel (10, 11) zum Befestigen des Flanschs (3) mit dem mindestens einen Chip (2) und dem Substrat (4) an der mindestens einen Kühlvorrichtung.

13. Chippaketanordnung (1) nach einem der Ansprüche 1 bis 12, wobei das dielektrische Substrat (12) plattenförmig ist.

14. Chippaketanordnung (1) nach einem der Ansprüche 1 bis 13, aufweisend eine Ummantelung (13), um den mindestens einen Chip (2) und die Anschlüsse zu schützen, insbesondere eine abnehmbare Ummantelung (13), und/oder aufweisend Schrauben durch dielektrische Hülsen hindurch, um den mindestens einen Chip (2), das Substrat (4) und den Flansch (3) an der mindestens einen Kühlvorrichtung zu befestigen.

15. Verfahren zur Verwendung der Chippaketanordnung (1) nach einem der Ansprüche 1 bis 14,
**dadurch gekennzeichnet, dass** das Chippaket demontierbar ist, insbesondere, um den mindestens einen Chip (2) von dem Substrat (4) zu demontieren, insbesondere, um den mindestens einen Chip (2) durch einen anderen Chip (2) auszutauschen.

## Revendications

1. Ensemble boîtier (1) de puces permettant de monter au moins une puce à semi-conducteur (2), comprenant une bride (3) et un substrat (4), l'au moins une puce (2) et le substrat (4) étant agencés sur un côté de la bride (3), la bride (3) étant composée d'un matériau électroconducteur et thermoconducteur, dans lequel l'ensemble boîtier de puces comprend en outre au moins un dispositif de refroidissement et dans lequel
**caractérisé en ce que**,
un substrat diélectrique (12) est agencé entre la bride (3) et l'au moins un dispositif de refroidissement, et agencé sur le côté opposé de la bride (3) par rapport au côté de la bride (3) où sont agencés l'au moins une puce (2) et le substrat (4).

2. Ensemble boîtier (1) de puces selon la revendication 1,
**caractérisé en ce que** le matériau conducteur de la bride (3) comprend ou est un métal, en particulier un métal ayant une thermoconductivité élevée, en particulier du cuivre.

3. Ensemble boîtier (1) de puces selon l'une quelconque des revendications 1 ou 2, **caractérisé en ce que** le substrat (4) comprend un matériau présentant de faibles pertes à haute fréquence, en particulier le substrat (4) est constitué d'un matériau de carte de circuits imprimés.

4. Ensemble boîtier (1) de puces selon l'une quelconque des revendications 1 à 3, **caractérisé en ce que** l'au moins une puce (2) comprend une connexion de contact de drain de transistor au niveau du côté inférieur (2b), où le côté inférieur (2b) est le côté tourné vers la bride (3) et est particulièrement en regard du côté (2a) avec les autres contacts électriques de l'au moins une puce (2).

5. Ensemble boîtier (1) de puces selon l'une quelconque des revendications 1 à 4, **caractérisé en ce que** l'au moins une puce (2) et/ou le substrat (4) sont montés sur un côté de la bride (3) à l'aide d'une brasure, d'un alliage eutectique, d'un adhésif électroconducteur et/ou d'une pâte de frittage (5).

6. Ensemble boîtier (1) de puces selon l'une quelconque des revendications 1 à 5, **caractérisé en ce que** les connecteurs de l'au moins une puce (2), en particulier les connecteurs sur le côté de l'au moins une puce (2) en regard du côté tourné vers la bride (3), sont connectés au substrat (4) par liaison, en particulier par liaison avec des fils et/ou des lignes à ruban (6).

7. Ensemble boîtier (1) de puces selon l'une quelconque des revendications 1 à 6, comprenant des prises électriques (7) pour des exigences haute fréquence connectables à des dispositifs externes, en particulier à une carte de circuits imprimés d'amplificateur.

8. Ensemble boîtier (1) de puces selon l'une quelconque des revendications 1 à 7, **caractérisé en ce que** le substrat (4) comprend des endroits métallisés (8) de côté d'extrémité pour un contact électrique, en particulier en contact électrique avec l'au moins une puce (2), pour un contact électrique avec au moins un dispositif externe.

9. Ensemble boîtier (1) de puces selon la revendication 8, **caractérisé en ce que** les endroits métallisés (8) de côté d'extrémité sont agencés au niveau de la face latérale du substrat (4) et/ou brasés pour un contact avec l'au moins un dispositif externe.

10. Ensemble boîtier (1) de puces selon l'une quelconque des revendications 1 à 9, comprenant une isolation électrique (9) entre les connecteurs de l'au moins une puce (2) et la bride (13).

11. Ensemble boîtier (1) de puces selon l'une quelconque des revendications 1 à 10, dans lequel au moins un dispositif de refroidissement est un bloc de refroidissement.

12. Ensemble boîtier (1) de puces selon la revendication 11, comprenant des moyens (10, 11) permettant de monter la bride (3) avec l'au moins une puce (2) et le substrat (4) sur l'au moins un dispositif de refroidissement.

13. Ensemble boîtier (1) de puces selon l'une des revendications 1 à 2, comprenant le substrat diélectrique (12) est en plaque.

14. Ensemble boîtier (1) de puces selon l'une des revendications 1 à 13, comprenant une encapsulation (13) pour protéger l'au moins une puce (2) et des connecteurs, en particulier une encapsulation amovible (13), et/ou comprenant des vis à travers des manchons diélectriques pour fixer l'au moins une puce (2), le substrat (4) et la bride (3) à l'au moins un dispositif de refroidissement.

15. Procédé d'utilisation de l'ensemble boîtier (1) de puces selon l'une quelconque des revendications 1 à 14,
**caractérisé en ce que** le boîtier de puces est démonté, en particulier pour démonter l'au moins une puce (2) du substrat (4), en particulier pour remplacer l'au moins une puce (2) par une autre puce (2).
